# EUROPÄISCHE PATENTSCHRIFT

(11) **EP 1 062 729 B1**
(45) Veröffentlichungstag und Bekanntmachung des Hinweises auf die Patenterteilung: **29.05.2002**
(21) Anmeldenummer: 98959742.2
(22) Anmeldetag: 20.10.1998
(51) Int. Cl.: H03K 17/968

(54) **ELEKTRONISCHES GERÄT MIT BELEUCHTETEN BEDIENTASTEN, WOBEI DIE BETÄTIGUNG DER BEDIENTASTEN DURCH DIE ERFASSUNG DER ÄNDERUNG DER LICHTREFLEKTION FESTGESTELLT WIRD**
ELECTRONIC DEVICE WITH ILLUMINATED OPERATOR BUTTONS, THE ACTIVATION OF SAID OPERATOR BUTTONS BEING DETERMINED BY DETECTION OF THE CHANGE IN THE LUMINOUS REFLECTANCE
APPAREIL ELECTRONIQUE A TOUCHES DE COMMANDE ECLAIREES, L'ACTIONNEMENT DE CES DERNIERES ETANT DETERMINE PAR LA DETECTION DE LA VARIATION DE LA REFLEXION DE LA LUMIERE

(30) Priorität: 07.03.1998 DE 19809886
(43) Veröffentlichungstag der Anmeldung: 27.12.2000
(73) Patentinhaber: ROBERT BOSCH GMBH, 70442 Stuttgart (DE)
(72) Erfinder: RYCHLAK, Stefan, D-31241 Ilsede (DE)
(86) Internationale Anmeldenummer: DE9803070
(87) Internationale Veröffentlichungsnummer: WO9945649

(56) Entgegenhaltungen:
- EP-A- 0 448 826
- DE-A- 3 611 988
- DE-A- 19 615 051
- DE-C- 19 632 334

## Beschreibung

Die Erfindung betrifft ein elektronisches Gerät, insbesondere Autoradio, mit einem Mikroprozessor und mit Bedientasten, die durch Lichtquellen beleuchtbar sind.

Derartige elektronische Geräte findet man insbesondere als Geräte der Unterhaltungselektronik, die auch bei einer spärlichen Beleuchtung bedienbar sein sollen. Bei Autoradios hat das "Nachtdesign" die Funktion, die Bedientasten im bei fehlendem Tageslicht im wesentlichen dunklen Inneraum des Kraftfahrzeugs auffindbar und bedienbar zu machen.

Solche Geräte sind aus DE-A-3 611 988 und aus EP-A-0 448 826 bekannt.

Bedientasten in Autoradios werden zur Zeit üblicherweise als Kurzhub-Tipptasten mit Auswertung eines Schaltimpulses oder durch einen ständigen Kontakt herstellenden leitenden Gummimatten, die auch die Rückstellkraft der Tasten bewirken, realisiert.

Die bekannten Bedientasten müssen mechanisch und elektrisch zuverlässig ausgebildet sein. Für die benötigte Lebensdauer der Tasten ist die mechanische Abnutzung von Kontakten oder des Leitgummis der Gummimatten entscheidend. Um die benötigte hohe Lebensdauer zuverlässig zu erreichen, müssen die Bedientasten relativ aufwendig ausgeführt werden, so daß sie ein nicht zu vernachlässigendes kostenbestimmendes Element für Autoradios darstellen.

Die Erfindung geht somit von der Problemstellung, ein Konzept für Bedientasten eines elektronischen Geräts zu erstellen, das eine hohe Lebensdauer der Bedientasten bei einem verringerten Aufwand ermöglicht.

Zur Lösung dieses Problems ist erfindungsgemäß ein elektronisches Gerät gemäß Anspruch 1 vorgesehen.

Durch die vorliegende Erfindung wird die Beleuchtungsfunktion für die Bedientasten mit der Detektion der Tastenbetätigung kombiniert. Im Gegensatz zu den üblicherweise verwendeten Lösungen für Autoradios und entsprechende elektronische Geräte wird die Tastenbetätigung nicht elektrisch detektiert sondern mit Hilfe des Beleuchtungslichts. Um dies zu ermöglichen, wird das Beleuchtungslicht in Form von so schnell aufeinanderfolgenden Lichtimpulsen erzeugt, daß das menschliche Auge die Beleuchtung durch jede Lichtquelle als kontinuierlich wahrnimmt. Entsprechend hochfrequent getaktete Impulse werden zyklisch vom Mikroprozessor gesteuert auf die Lichtquellen verteilt, so daß jedem Steuerimpuls des Mikroprozessors eine Lichtquelle zugeordnet ist. Durch die am Mikroprozessor ankommenden Ausgangssignale der Lichtempfängeranordnungen kann der Mikroprozessor somit festellen, welchen Betätigungszustand die zu dem bestimmten Steuerimpuis gehörende Betätigungstaste gerade einnimmt, indem der Mikroprozessor feststellt, daß zu dem Ausgangs-Steuerimpuls ein entsprechender Impuls der Lichtempfängeranordnung auf seinen Eingang gelangt oder nicht. Im Rahmen der erfindungsgemäßen Anordnung ist es ohne weiteres möglich, auch eine Dimmfunktion zu realisieren, indem die Taktfrequenz des Mikroprozessors verändert wird oder die Impulsbreiten der zyklisch verteilten Steuerimpulse variiert werden.

In einer gestaltungstechnisch bevorzugten Ausführungsform der Erfindung sind die Lichtquellen an Ausgängen eines Schieberegisters angeschlossen, das seinerseits an einen Taktimpuls-Ausgang des Mikroprozessors angeschlossen ist. Die zyklische Verteilung der Steuerimpulse erfolgt dabei über das vom Mikroprozessor getaktete Schieberegister. Zweckmäßigerweise ist dabei ferner das Schieberegister an einen Reset-Ausgang des Mikroprozessors angeschlossen, so daß das Schieberegister nach der Abfrage der Betätigungstasten in einen definierten Anfangszustand zurückgestellt wird, um die sichere Zuordnung von Taktimpulsnummern des Mikroprozessors zu den über das Schieberegister auf die einzelnen Lichtquellen nacheinander verteilten Steuerimpulse zu gewährleisten.

Die Lichtempfängeranordnung einer Betätigungstaste weist zweckmäßigerweise eine Lichtleiter-Anordnung auf. Dadurch ist es möglich, daß empfangene Licht aller Bedientasten gemeinsam auszuwerten, beispielsweise einem gemeinsamen opto-elektrischen Wandler zuzuführen, wodurch sich eine sehr einfache und preiswerte Auswertungsanordnug ergibt.

Für die Detektion des Bedienzustandes der Bedientaste kann eine Verschiebebewegung der Bedientaste ausgenutzt werden. Es ist im Rahmen der Erfindung auch möglich, Bedientasten zu verwenden, die ohne jede Verschiebebewegung betätigbar sind. Dabei kann in an sich bekannter Weise das Reflektionsvermögen des Betätigungsfingers einer Bedienperson ausgenutzt werden, in dem das aus der Betätigungstaste austretende Beleuchtungslicht über den Bedienfinger in eine Stirnfläche eines Lichtleiterkabels reflektiert wird. Für speziell geformte Tastenmulden ist es auch denkbar, eine ständige optische Verbindung zwischen dem Lichtaustritt und der Stirnfläche einer Lichtleiteranordnung herzustellen, die durch einen die Betätigungstaste betätigenden Finger unterbrochen wird.

Für eine hohe Zuverlässigkeit der Detektion des Betätigungszustandes der Betätigungstaste mit einer sehr einfachen Anordnung ist es vorgesehen, daß in jeder Betätigungstaste ein Lichtleiterstück zum ständigen Empfang eines Lichtanteils der Lichtquelle angeordnet ist, daß die Bedientaste zur Betätigung verschiebbar ist und daß die Verschiebebewegung der Bedientaste das Lichtleiterstück relativ zu einem von der Betätigungstaste wegführenden Lichtleiterkabel verschiebt. Abhängig vom Betätigungszutand der Betätigungstaste wird das vom Lichtleiterstück aufgefangene Licht im Lichtleiterkabel abgeleitet oder gelangt nicht in das Lichtleiterkabel. Da die Lichtleiter sehr dünn ausgeführt sein können, wird eine nur geringfügige Verschiebebewegung benötigt, um den Bedienzustand sicher detektieren zu können. Bevorzugt ist dabei, daß beim Drücken der Betätigungstaste die optische Verbindung zwischen Lichtleiterstück und Lichtleiterkabel unterbrochen wird, da so im Ruhezustand der Betätigungstaste die ordnungsgemäße Funktion der Anordnung vom Mikroprozessor überprüfbar ist.

Die Erfindung soll im folgenden anhand eines in der Zeichnung dargestellten Ausführungsbeispiels näher erläutert werden. Es zeigen:
- Figur 1 -: ein Prinzipschaltbild für eine Bedientastenanordnung mit zwei Bedientasten in nicht gedrückter Stellung,
- Figur 2 -: eine Darstellung gemäß Figur 1 mit einer gedrückten Bedientaste.

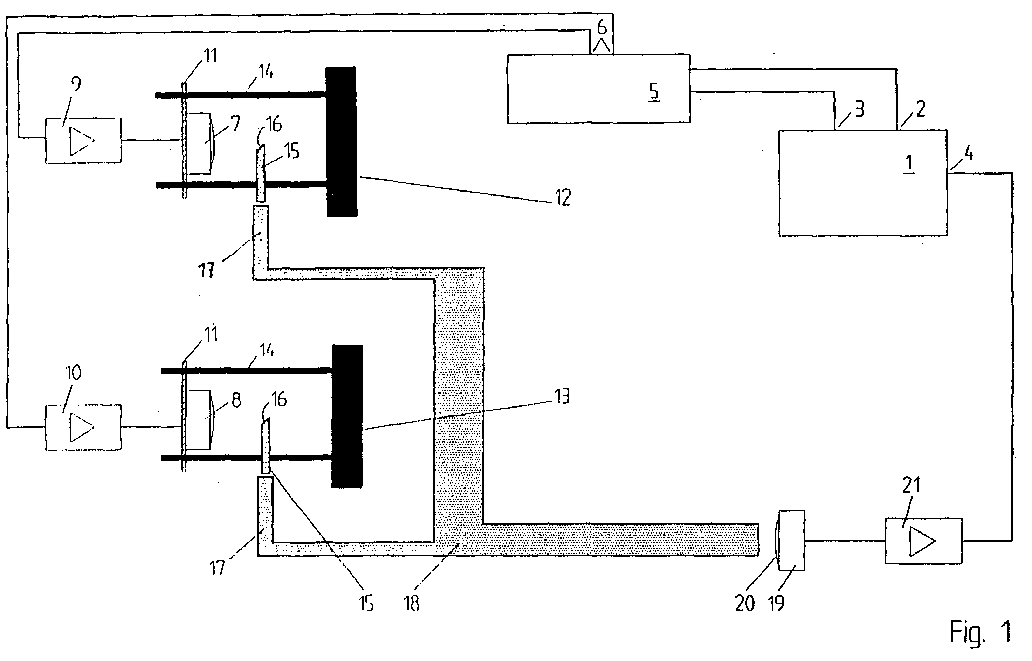

In Figur 1 ist ein Mikroprozessor 1 mit einem Taktausgang 2 und einem Resetausgang 3 sowie einem Eingang 4 dargestellt. Mit den beiden Ausgängen 2, 3 ist ein Schieberegister 5 mit funktional zugehörigen Eingängen verbunden. Das Schieberegister weist in dem dargestellten Ausführungsbeispiel zwei Ausgänge 6 auf, die jeweils mit einer Lichtquelle 7, 8 über einen jeweils zugehörigen Verstärker 9, 10 verbunden sind.

Die Lichtquellen 7, 8 sind als Leuchtdioden ausgebildet und auf einer Leiterplatte 11, die eine gemeinsame Leiterplatte sein kann, ortsfest montiert. Eine erste Betätigungstaste 12 und eine zweite Betätigungstaste 13 sind mit hohlzylindrischen Gehäuseansätzen 14 versehen, die die zugehörige Lichtquelle 7, 8 umschließen und, beispielsweise in Verbindung mit der Leiterplatte 11 eine Führung für eine Verschiebung der Betätigungstaste 12, 13 senkrecht zu ihrer Betätigungsfläche bewirken. Die Betätigungstasten 12, 13 sind an ihrer Oberfläche zumindest teillichtdurchlässig, um die Beleuchtungsfunktion zu ermöglichen. In den hohlzylindrischen Gehäuseansatz 14 ist jeweils ein Lichtleiterstück 15 eingesetzt, das mit einer abgeschrägten Stirnkante 16 einen Teil des Lichts der Lichtquelle 7, 8 auffängt und durch eine Öffnung des hohlzylindrischen Gehäuseansatzes 14 nach außen leitet. Das Lichtleiterstück 15 ist somit mit der Betätigungstaste 12, 13 verschiebbar. In der in Figur 1 dargestellten Ruhestellung der beiden Tasten 12, 13 fluchtet eine ebene ausgangsseitige Stirnfläche des Lichtleiterstücks 16 mit einer ebenen Stirnfläche eines ortsfest montierten Lichtleiterkabel 17, so daß in dem in Figur 1 dargestellten Zustand ein Teil des von den Lichtquellen 7, 8 ausgesandten impulsförmigen Lichts über das Lichtleiterstück 16 und das Lichtleiterkabel 17 abgeleitet wird. Die Lichtleiterkabel 17 werden zu einem Lichtleiterbündel 18 vereint, das vor einer lichtempfindlichen Fläche eines hier als Phototransistor ausgebildeten opto-elektrischen Wandlers 19 endet. Der Phototransistor ist auf seiner optischen Eingangsseite üblicherweise mit einer Sammellinse 20 versehen.

Das elektrische Ausgangssignal des opto-elektrischen Wandlers 19 gelangt über einen Verstärker 21 auf den Eingang 4 des Mikroprozessors 1.

Bei dem in Figur 1 dargestellten vereinfachten Ausführungsbeispiel sendet der Mikroprozessor 1 jeweils zwei Taktimpulse über den Taktausgang 2 auf das Schieberegister 5, das somit zwei Impulse nacheinander auf die erste Lichtquelle 7 und auf die zweite Lichtquelle 8 leitet. Danach sendet der Mikroprozessor 1 über den Reset-Ausgang 3 einen Reset-Impuls auf das Schieberegister 5, so daß dieses nach dem Aussenden der beiden Impulse auf die beiden Lichtquellen 7, 8 in einen definierten Ausgangszutand, der dem Zyklusanfang entspricht, zurückgestellt wird. Während der Aussendung der beiden Taktimpulse über den Taktausgang 2 empfängt der Mikroprozessor jeweils einen Impuls am Eingang 4, so daß der Mikroprozessor 1 erkennen kann, daß sich beide Betätigungstasten 12, 13 im unbetätigten Ruhezustand befinden.

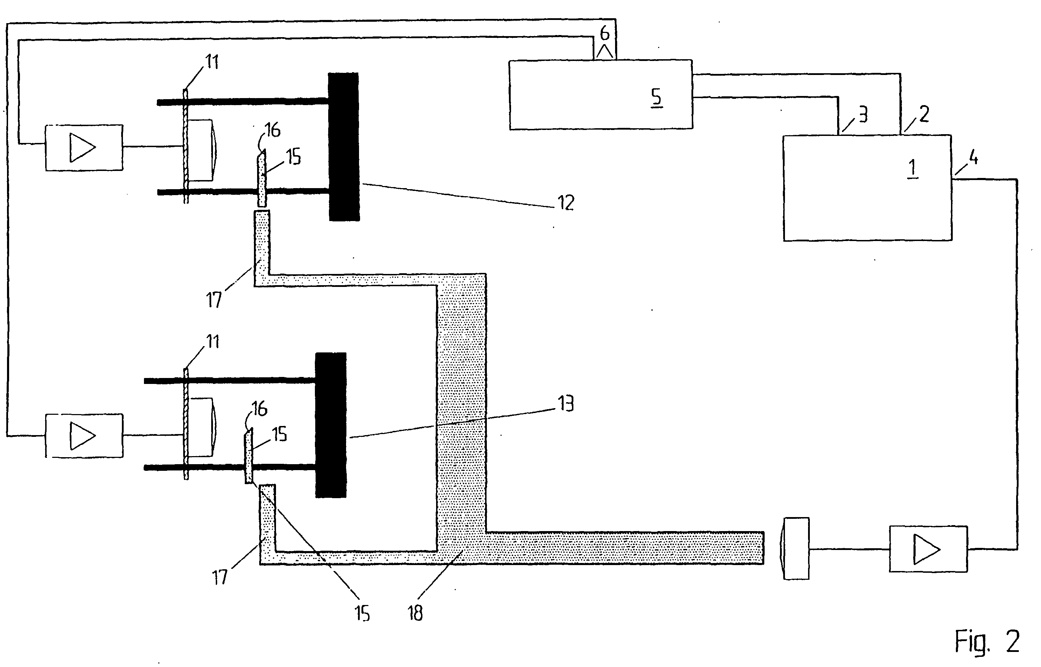

Bei dem in Figur 2 dargestellten Ausführungsbeispiel ist lediglich die zweite Betätigungstaste 13 betätigt worden. Demgemäß empfängt der Mikroprozessor 1 nur beim Aussenden des ersten Taktimpules über den Taktausgang 2 ein Impulssignal an seinem Eingang 4, nicht jedoch beim Aussenden des zweiten Taktimpulses eines Zyklus. Somit erkennt der Mikroprozessor 1, daß sich die erste Bedientaste 12 im nicht betätigten Ruhezustand, die zweite Bedientaste 13 jedoch im eingedrückten Zustand befindet.

Selbstverständlich ist das dargestellte Ausführungsbeispiel auf eine beliebige Anzahl von Bedientasten erweiterbar. Sind beispielsweise acht Bedientasten vorhanden, wird das Schieberegister 5 mit acht Ausgängen gebildet, so daß der Mikroprozessor jeweils acht Taktimpulse am Taktausgang 2 aussendet, bevor der Reset-Impuls über den Reset-Ausgang 3 auf das Schieberegister 5 geleitet wird, um den Anfang des nächsten Zyklus zu definieren.

## Patentansprüche

1. Elektronisches Gerät, insbesondere Autoradio mit einem Mikroprozessor (1) und mit Bedientasten (12, 13), denen Lichtquellen (7, 8) zugeordnet sind,
wobei jede Bedientaste (12, 13) zur optischen Verbindung der Lichtquelle (7, 8) mit einer Lichtempfängeranordnung (17, 19) ausgebildet ist,
wobei mit der Bedientaste (12, 13) ein Lichtleiterstück (15) zum ständigen Empfang eines Lichtanteils der Lichtquelle (7, 8) verbunden ist,
wobei die Bedientaste (12, 13) zur Betätigung verschiebbar ist,
und wobei die optische Verbindung zwischen Lichtquelle (7, 8) und Lichtempfängeranordnung (17, 19) durch die Betätigung der betreffenden Bedientaste (12, 13) veränderbar ist,
**dadurch gekennzeichnet,**
**daß** die Lichtquellen (7, 8) vom Mikroprozessor (1) gesteuert nacheinander zyklisch mit Steuerimpulsen versorgbar sind,
**daß** der Mikroprozessor (1) für eine Zuordnung der Ausgangssignale der Lichtempfängeranordnungen (15, 17, 19) zu den zyklisch ausgesandten Impulsen eingerichtet ist,
und **daß** die Verschiebungsbewegung der Bedientaste (12, 13) das Lichtleiterstück (15) relativ zu einem von der Bedientaste (12, 13) wegführenden Lichtleiterkabel (17) verschiebt.

2. Elektronisches Gerät nach Anspruch 1, **dadurch gekennzeichnet, daß** die Lichtquellen (7, 8) an Ausgängen (6) eines Schieberegisters (5) angeschlossen sind, das an einen Taktimpulsausgang (2) des Mikroprozessors (1) angeschlossen ist.

3. Elektronisches Gerät nach Anspruch 2, **dadurch gekennzeichnet, daß** das Schieberegister (5) ferner an einen Resetausgang (3) des Mikroprozessors (1) angeschlossen ist.

4. Elektronisches Gerät nach einem der Ansprüche 1 bis 3, **dadurch gekennzeichnet, daß** die Lichtleiteranordnungen (15, 17) mehrerer Bedientasten (12, 13) gemeinsam an einer lichtempfindlichen Fläche eines optoelektronischen Wandlers (19) enden, dessen Ausgangssignal mit einem Eingang des Mikroprozessors (1) verbunden ist.

## Claims

1. Electronic device, in particular car radio, having a microprocessor (1) and having operating buttons (12, 13), which are assigned light sources (7, 8),
each operating button (12, 13) being designed for optical connection of the light source (7, 8) to a light receiver arrangement (17, 19),
there being connected to the operating button (12, 13) an optical waveguide portion (15) for continuously receiving a proportion of light from the light source (7, 8),
the operating button (12, 13) being displaceable for actuation,
and the optical connection between light source (7, 8) and light receiver arrangement (17, 19) being able to be altered by the actuation of the relevant operating button (12, 13),
**characterized**
**in that** the light sources (7, 8) can be supplied with control pulses cyclically one after the other under the control of the microprocessor (1),
**in that** the microprocessor (1) is set up for assigning the output signals of the light receiver arrangements (15, 17, 19) to the cyclically emitted pulses,
and **in that** the displacement movement of the operating button (12, 13) displaces the optical waveguide portion (15) relative to a fibre-optic cable (17) leading away from the operating button (12, 13).

2. Electronic device according to Claim 1, **characterized in that** the light sources (7, 8) are connected to outputs (6) of a shift register (5), which is connected to a clock pulse output (2) of the microprocessor (1).

3. Electronic device according to Claim 2, **characterized in that** the shift register (5) is furthermore connected to a reset output (3) of the microprocessor (1).

4. Electronic device according to one of Claims 1 to 3, **characterized in that** the optical waveguide arrangements (15, 17) of a plurality of operating buttons (12, 13) jointly end at a light-sensitive area of an optoelectronic transducer (19) whose output signal is connected to an input of the microprocessor (1).

## Revendications

1. Appareil électronique, en particulier autoradio équipé d'un microprocesseur (1) et de touches de commande (12, 13) auxquelles sont associées des sources lumineuses (7, 8), dans lequel :
- chaque touche de commande (12, 13) est constituée pour assurer la liaison optique entre la source lumineuse (7, 8) et un dispositif récepteur de lumière (17, 19),
- à la touche de commande (12, 13) est relié un morceau de conducteur de lumière (15) pour recevoir en permanence une partie de la lumière émise par la source (7, 8), les touches (12, 13) étant actionnées par coulissement et
- la liaison optique entre la source lumineuse (7, 8) et le dispositif récepteur de lumière (17, 19) peut être modifiée par actionnement de la touche de commande concernée (12, 13),
**caractérisé en ce que**
- les sources lumineuses (7, 8) commandées par le microprocesseur (1) peuvent être alimentées de manière cyclique par des impulsions successives,
- le microprocesseur (1) est conçu pour associer les signaux de sortie des dispositifs récepteurs de lumière (15, 17, 19) aux impulsions émises cycliquement, et
- le mouvement de coulissement des touches de commande (12, 13) écarte le morceau de conducteur de lumière (15) par rapport à un câble conducteur de lumière (17) partant de la touche de commande (12, 13).

2. Appareil électronique selon la revendication 1,
**caractérisé en ce que**
les sources lumineuses (7, 8) sont raccordées à des sorties (6) d'un registre à décalage (5) lui-même raccordé à une sortie d'impulsions de rythme (2) du microprocesseur (1).

3. Appareil électronique selon la revendication 1,
**caractérisé en ce que**
le registre à décalage (5) est raccordé de plus à une sortie de remise à l'état initial (3) du microprocesseur (1).

4. Procédé selon l'une quelconque des revendications 1 à 3,
**caractérisé en ce que**
les dispositifs conducteurs de lumière (15, 17) de plusieurs touches de commande (12, 13) se terminent ensemble à la surface réceptrice de lumière d'un convertisseur optoélectronique (19), dont le signal de sortie est relié à une entrée du microprocesseur (1).
